Europäisches Patentamt

(19) European Patent Office

Office européen des brevets

(11) Publication number: **0 059 630**

**B1**

(12) **EUROPEAN PATENT SPECIFICATION**

(45) Date of publication of patent specification: **22.10.86**          (51) Int. Cl.⁴: **G 11 C 17/00**

(21) Application number: **82301020.2**

(22) Date of filing: **01.03.82**

(54) **Field programmable device.**

(30) Priority: **02.03.81 JP 29727/81**

(43) Date of publication of application:
**08.09.82 Bulletin 82/36**

(45) Publication of the grant of the patent:
**22.10.86 Bulletin 86/43**

(84) Designated Contracting States:
**DE FR GB**

(56) References cited:
**EP-A-0 018 192**
**EP-A-0 019 381**

**IBM TECHNICAL DISCLOSURE BULLETIN, vol.
18, no. 6, November 1975, pages 1798-1799,
New York, USA F. BUCKLEY et al.: "Pipe
tolerant inverted transistor read-only store"**

**JAPANESE JOURNAL OF APPLIED PHYSICS,
vol. 19, supplement 19-1, 1980, pages 175-180,
Tokyo, JP. T. FUKUSHIMA et al.: "A high-speed
Schottky 4 k-Bit PROM using diffused eutectic
aluminum Process (Deap)"**

(73) Proprietor: **FUJITSU LIMITED**
**1015, Kamikodanaka Nakahara-ku
Kawasaki-shi Kanagawa 211 (JP)**

(72) Inventor: **Ueno, Kouji**
**1360, Shukugawara Tama-ku
Kawasaki-shi Kanagawa, 214 (JP)**
Inventor: **Miyamura, Tamio**
**1149 Shimokodanaka Nakahara-ku
Kawasaki-shi Kanagawa, 211 (JP)**

(74) Representative: **Sunderland, James Harry et al
HASELTINE LAKE & CO Hazlitt House 28
Southampton Buildings Chancery Lane
London WC2A 1AT (GB)**

## Description

The present invention relates to a field programmable bipolar semiconductor memory device, for example a programmable read-only memory (P-ROM) including junction-shorting type memory cells.

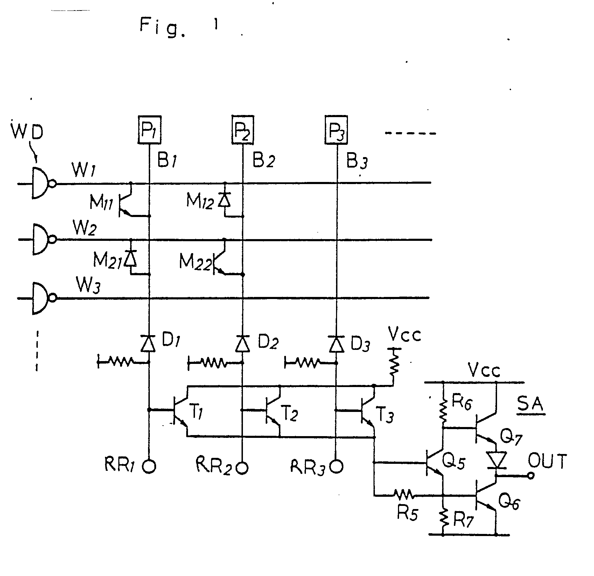

Figure 1 of the accompanying drawings schematically illustrates a so-called programmable device the contents of a ROM of which can be written in accordance with a user's needs — a field programmable device.

As shown in Figure 1, a programmable ROM device has memory cells each of the junction breakdown type and each having the structure (in an unwritten state) of a transistor whose base is not wired. Such memory cells $M_{11}$, $M_{12}$ ... are connected at the points of intersection of word lines $W_1$ $W_2$ ... and bit lines $B_1$, $B_2$ ... .

A writing operation, for writing data into a cell, is carried out in such a way that the cell is supplied with a writing current (programming current) to break down the emitter-base junction of the cell transistor (i.e. to bring the cell into its conductive state) and thus turn the cell into a P-N diode (e.g. $M_{12}$ or $M_{21}$ in Figure 1) formed of the base-collector junction of the transistor thereof. To program, or write into, the whole memory bit lines and word lines are sequentially selected in accordance with data to be written, and a writing operation is executed for each desired cell, each cell being located at the intersection point of a particular word line and a particular bit line.

The inventors of the present invention have discovered that problems can arise in such writing operations.

One problem with which the present inventors are concerned is the formation of a P-N-P-N structure between a cell in respect of which a writing operation has been completed and which cell has become a diode, and a cell in respect of which a cell writing operation has not been completed and which remains a transistor. To program the ROM stably and reliably, writing current for writing into a cell needs to flow between a selected bit line and word line without turning such a P-N-P-N structure "on", to permit the writing current to be supplied to the cell to be written at the intersection point of the selected bit and word lines.

Moreover, the word lines of the ROM are formed of a diffused layer. In the case in which the diffused layer has defects and in which a non-selected word line, which ought to hold a high withstand voltage during a writing operation, allows current to leak out, programming (writing) current undesirably flows out to the substrate of a cell through a parasitic P-N-P transistor which is formed by the cell and the substrate. Even when the leakage current is small it is multiplied by $\beta$ (a current gain factor) by means of the P-N-P transistor. Therefore, leakage current should be suppressed as much as possible.

In an article by FUKUSHIMA et al in Japanese Journal of Applied Physics, Vol. 19 Supplement 19-1, 1980 entitled "A high-speed Schottky 4K-Bit PROM using diffused eutectic aluminium process (Deap)", there is disclosed the existence of a so-called parasitic SCR between a programmed memory cell and a neighbouring unprogrammed memory cell in a shorted-junction type PROM device. It is stated that such a parasitic SCR may be turned on and latched during programming. The article also discloses the existence of a parasitic vertical pnp transistor formed by the base of a standard npn transistor, epitaxial layer and substrate in such a device, and the possibility of current leakage through such a parasitic transistor.

According to the present invention there is provided a field programmable bipolar semiconductor memory device, comprising a plurality of word lines, a plurality of bit lines arranged to cross the word lines, and a plurality of memory cells arranged in a single semiconductor substrate each connected to a bit line and a word line, characterised in that the device further comprises supply means operable for supplying non-selected word lines with a voltage sufficient to prevent turn-on of a parasitic P-N-P-N element formed by memory cells of the device, and operable for supplying non-selected word lines with a voltage sufficient to prevent leakage of a writing or programming current, delivered via a selected bit line, through a parasitic P-N-P transistor formed in a previously written or programmed memory cell on the selected bit line.

It will be understood that non-selected word lines are word lines through which a writing or programming current delivered via bit line is not intended to flow when a memory cell is to be written or programmed.

It will be understood that a selected bit line is a bit line through which the writing or programming current is to flow to a memory cell to be written or programmed.

An embodiment of the present invention can provide a solution to the problems mentioned above and can provide a programmable device which is capable of stable and reliable programming.

In an embodiment of the present invention the turn-on of a P-N-P-N structure in a junction breakdown type memory (the P-N-P-N structure being formed by a memory cell into which data has been written and which has become a diode, and a memory cell into which data has not been written and which remains a transistor) can be prevented.

Further, in an embodiment of the present invention a leakage current in a junction breakdown type memory which leakage current is attributable to a vertical type parasitic transistor which appears in the writing mode of the memory, is suppressed.

Reference is made, by way of example, to the accompanying drawings, in which:—

Figure 1 is a circuit diagram schematically illustrating a P-ROM,

Figures 2 and 3 are circuit diagrams illustrating

respective word driver arrangements which can be employed in the P-ROM of Figure 1,

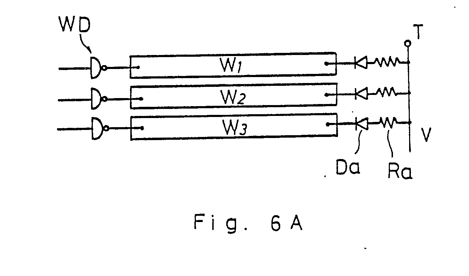

Figure 4 is a schematic sectional view illustrating the structure of a part of the P-ROM of Figure 1,

Figure 5 is an equivalent circuit diagram of main parts of the structure of Figure 4,

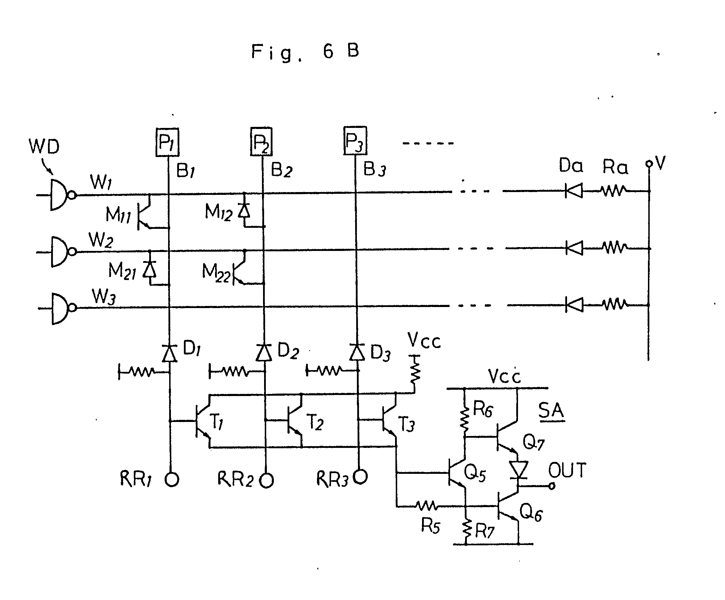

Figure 6A is a circuit diagram illustrating a first embodiment of the present invention, and Figure 6B is a more detailed circuit diagram of the first embodiment,

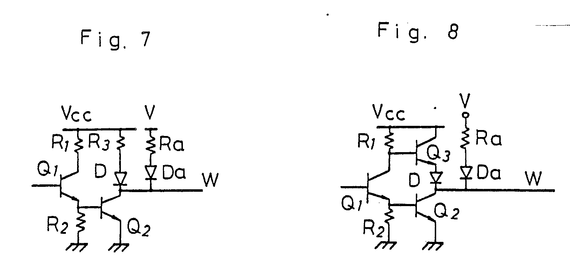

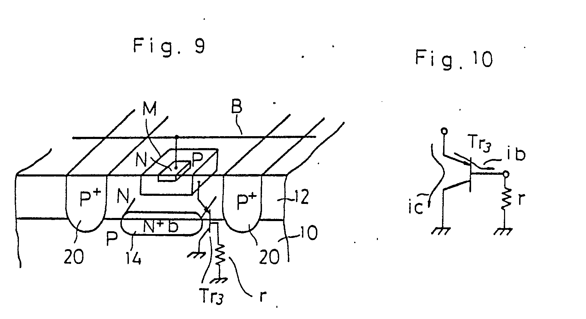

Figures 7 and 8 are circuit diagrams illustrating second and third embodiments of the present invention, respectively,

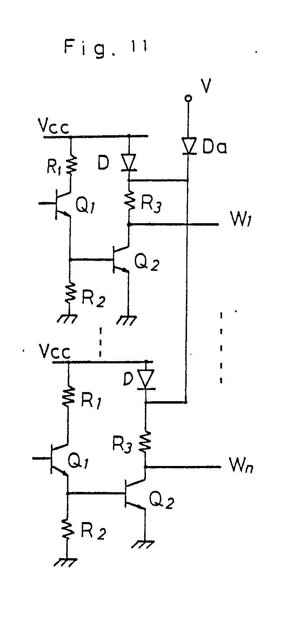

Figure 9 is a schematic perspective and sectional view, and Figure 10 is an equivalent circuit diagram, for assistance in explanation of a problem which can arise with the memory structure illustrated in Figure 4, and

Figure 11 is a circuit diagram of a fourth embodiment of the present invention.

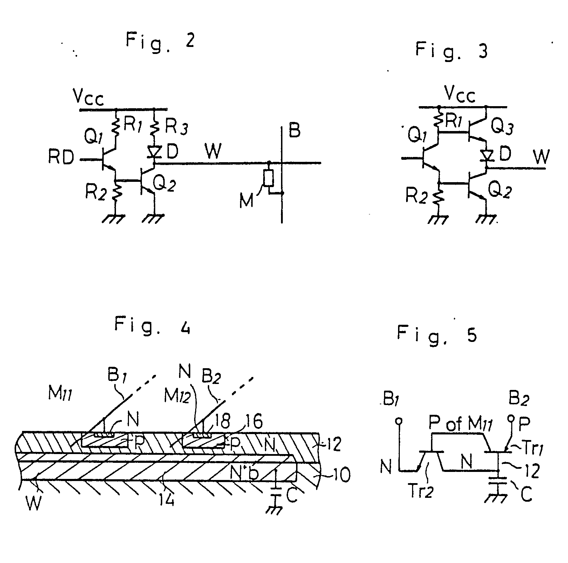

Referring to Figure 1 again, WD indicates word drivers which drive corresponding word lines to H (high) or L (low) level. As illustrated in Figures 2 and 3, the circuit arrangement of a word driver consists of transistors $Q_1$ and $Q_2$ (Figure 2) or $Q_1$ to $Q_3$ (Figure 3), resistors $R_1$ to $R_3$ (Figure 2) or $R_1$ and $R_2$ (Figure 3) and a diode D. In operation, in either Figure 2 or Figure 3, transistor $Q_1$, the input transistor, receives an output RD from a row decoder, and an output stage of the word driver (transistor $Q_2$ in Figure 2, transistors $Q_2$ and $Q_3$ in Figure 3) drives a word line W. When the decoder output RD = H, the transistors $Q_1$ and $Q_2$ turn "on" (and in the case of Figure 3 the transistor $Q_3$ turns "off") so that the word line W becomes L level. This corresponds to a selected state of the word line W. In a non-selected state of the word line W, a decoder output RD = L is received, the transistors $Q_1$ and $Q_2$ turn "off" (and in the case of Figure 3 the transistor $Q_3$ turns "on") and the word line W becomes H level. The word driver of Figure 2 is of the so-called resistor drive type, whilst the word driver of Figure 3 is of the type provided with a so-called off-buffer.

In Figure 1, $P_1$, $P_2$ ... are programming terminals which, in the writing mode of the programmable ROM, are supplied with writing current. (More specifically, writing current is fed from a constant-current source of 120 mA or so, and the corresponding voltage is approximately 15 V at maximum. Supply voltage $V_{cc}$ is 5 V.)

In order to write data into, for example, the memory cell $M_{11}$, the word line $W_1$ is brought to L level by its corresponding word driver WD, and writing current is supplied from the terminal $P_1$ to the cell $M_{11}$. This cell $M_{11}$ has its emitter-base junction broken down and becomes a diode which allows current to flow from the bit line $B_1$ to the word line $W_1$.

In Figure 1, $RR_1$, $RR_2$, $RR_3$ ... are reading terminals which receive outputs from a column decoder when the P-ROM is in a reading mode.

By way of example, when a H (high) level voltage is applied to the terminal $RR_1$ with the word line $W_2$ selected, current flows through a path including the terminal $RR_1$, a diode $D_1$, the memory cell $M_{21}$, the word line $W_2$ and the corresponding word driver WD, and hence, the bit line $B_1$ becomes L (low) level. In consequence, a transistor $T_1$ is in an "off" state and a sense amplifier SA, which comprises resistors $R_5$ to $R_7$ and transistors $Q_5$ to $Q_7$, etc., has its transistors $Q_5$ and $Q_6$ turned "off" and its transistor $Q_7$ turned "on", so that an output OUT of the P-ROM becomes H (high) level. On the other hand, when an unwritten memory cell e.g. $M_{11}$ is selected, the corresponding bit line becomes H (high) level, and the output of the sense amplifier SA becomes L (low) level. In this way, the stored contents of the P-ROM are read out.

Figure 4 illustrates the physical structure of essential portions of such a P-ROM. 10 is a P-type semiconductor substrate, which is formed with an N-type epitaxial layer 12 on its surface and an $N^+$-type buried layer 14 within its interior. The epitaxial layer 12 is formed with P-type diffused regions 16, in each of which an N-type diffused region 18 is formed. Parts 12, 16 and 18 serve as the collector, base and emitter regions of a memory cell transistor, respectively. It is assumed that the memory cell $M_{11}$, having such a structure, has not been written, whereas it is assumed that memory cell $M_{12}$ has been written, as in the illustration of Figure 1. Since the emitter-base junction of the written cell $M_{12}$ is in a short-circuited state, the bit line $B_2$ has formed thereon a lateral P-N-P transistor ($Tr_1$ in the equivalent circuit diagram of Figure 5) which is constructed of the P-type region 16 of the cell $M_{12}$, the N-type layer 12, and the P-type region of the cell $M_{11}$. The unwritten cell $M_{11}$ has a vertical transistor ($Tr_2$ in Figure 5) structure constituted by N-type layer 18 and P-type layer 16 thereof, and the N-type layer 12. These transistors $Tr_1$ and $Tr_2$ and the bit lines $B_1$ and $B_2$ are connected as shown in Figure 5. As will be apparent from Figure 5, a P-N-P-N element, in other words an element having a structure resembling that of a thyristor, is thus effectively connected between the bit lines $B_2$ and $B_1$, that is, between the bit lines of the written cell and of the unwritten cell.

Since this P-N-P-N element does not have a trigger terminal, it may seem that it would not turn "on". However, the N-type layer 12 which acts as the base of the lateral transistor $Tr_1$ and as the collector of the vertical transistor $Tr_2$ has a large capacitance C (see Figure 5) with respect to the ground of the P-ROM. Therefore, when a voltage is applied to the bit line $B_2$, a charging current flows through a path consisting of the bit line $B_2$, the N-type layer 18 and the P-type layer 16, the N-type layer 12 and the capacitance C, and it triggers the P-N-P-N element. The transistor $Tr_1$ is rendered conductive, with the aforementioned charging current acting as its base current, and a collector current flows therein. This collector current becomes the base current of the transistor $Tr_2$, which renders the transistor $Tr_2$ conductive. Once the transistor $Tr_2$ has turned "on", the base current of the transistor $Tr_1$ is maintained by the transistor $Tr_2$, so that the transistors $Tr_1$ and $Tr_2$ hold their "on" states even when the charging current disappears. That is, since the collector voltage of the transistor $Tr_2$ is fixed to a voltage about 0.2 V higher than that of the bit line $B_1$, the base voltage of the transistor $Tr_1$ rises to prevent this transistor from turning "off".

In these conditions (with an unwritten cell on $B_1$ and a written cell on $B_2$) when it is intended to write data into another memory cell belonging to the bit line $B_2$, and a high voltage is applied to the bit line $B_2$, it can happen that writing current flows through a path consisting of the bit line $B_2$, the transistors $Tr_1$ and $Tr_2$ of Figure 5, the bit line $B_1$, a written cell belonging to the bit line $B_1$ and the selected word line, without being applied to the selected cell belonging to $B_2$ into which it is now intended to write data. (Of course, if the bit line $B_1$ includes no written cells, the aforementioned current outflow along the indicated path does not take place). This can happen when the above-mentioned 120 mA constant current source is connected.

The inventors of the present invention have arrived at a solution to this problem which in particular can cope with the problem in a junction breakdown type P-ROM.

Figures 6A and 6B illustrate a first embodiment of the present invention. As shown in Figure 6A, according to this embodiment of the present invention, a high voltage V is applied from an external terminal T to word lines $W_1$, $W_2$ ... through respective series circuits each of which consists of a resistor Ra and a diode Da. High voltage V may be supplied to the word lines through resistors Ra. Such measures taken, charging of the capacitance C referred to above (Figure 5) is effected on the basis of the voltage V applied to a word line, and there is no charging current based on the writing voltage applied to a bit line. Accordingly, the P-N-P-N element at $Tr_1$ and $Tr_2$ is not triggered by a flow of current through $B_2$, 18 and 16, 12 and C and does not turn "on", and data can be written into a memory cell, e.g. $M_{22}$, by applying writing current thereto.

Figure 6B illustrates in more detail the first embodiment of the present invention as shown in Figure 6A. Like parts are designated by like references in Figures 1 and 6B. The sense amplifier SA functions to read out the contents of memory cells.

Figures 7 and 8 illustrate second and third embodiments of the present invention in which high voltage V is applied to a word line W through a resistor Ra and a diode Da on the word driver sides of circuits as illustrated in Figures 2 and 3, respectively. Like parts are designated by like references in Figures 2, 3 and 7, 8.

Thus, the application of a sufficiently high voltage V to non-selected word lines prevents turn-on of such P-N-P-N elements and thereby charging current supplied through a selected bit line (e.g. $B_2$ in Figure 5) must pass through the cell to be written.

As will be seen from Figures 7 and 8, when a word line is selected, the corresponding word driver will still bring the line to L level despite the presence of Ra and Da, which when the word line is not selected bring it to voltage V.

When leakage occurs between a word line and another region (e.g. the substrate of a P-ROM) as explained above, a parasitic P-N-P transistor, the presence of which is inherent in a P-N junction and whose collector is the substrate, turns "on", with the result that a current corresponding to its collector current $i_b \cdot \beta$ ($i_b$ being the base current of the parasitic transistor) flows into the substrate. This phenomenon will be described with reference to Figures 9 and 10.

The parasitic P-N-P transistor is a vertical transistor $Tr_3$ whose emitter is a P-type base region of a memory cell M, whose base is an N-type collector region (14) of the memory cell M and whose collector is a P-type substrate 10. When a leakage resistance $r$ exists between the substrate 10 and the N-type layer 12 serving as a word line, the base current $i_b$ of the parasitic transistor $Tr_3$ flows in a written cell as illustrated in Figure 10, so that the transistor $Tr_3$ turns "on" to pass collector current $i_c$, equal to $i_b \cdot \beta$, to the substrate. In the case of the P-ROM, only a selected word line is at L level, with all other, non-selected, word lines at H level. Moreover, a selected bit line is given a HH level (the high voltage level used during writing operations) in the programming mode. Accordingly, when a selected bit line has a written cell connected thereto even if the word line of this cell is not selected and is therefore at H level, the selected bit line is still at HH level, so that a current $I_b$ flows and the current of the selected bit line flows to the substrate through the written cell. In contrast, if HH voltage is applied to the word line W, or N-type layer 12, as it is in an embodiment of the present invention, the base current $i_b$ does not flow and the aforementioned current outflow to the substrate is avoided. In Figure 9, 20 is a $P^+$-type isolation region.

Figure 11 shows a fourth embodiment of the present invention. The output stage of each word driver in Figure 11 (each word driver comprising resistors $R_1$ to $R_3$, transistors $Q_1$ and $Q_2$, and a diode D, and driving a respective word line $W_1$ ... $W_n$) consists of a transistor $Q_2$ and a resistor $R_3$. The transistor $Q_2$ has its emitter grounded, and has its collector connected to one end of the resistor $R_3$. The other ends of the resistors $R_3$ of the word drivers are connected to the cathodes of diodes D. Further, the cathode of a diode Da is connected to those of the diodes D. The anodes of the diodes D are connected to a voltage source $V_{cc}$, and the anode of the diode Da is connected to a further voltage source V. Although the first to third embodiemnts of the present invention described above may require a number of pairs of resistors Ra and diodes Da equal to the number of the word lines, the embodiment of Figure 11 requires only one diode Da which is provided in common for all the word lines. Further, in the second and third embodiments, respective diodes D are required for the word drivers, but the fourth embodiment of the present invention as shown can be modified and only one diode D employed in common for all the word drivers. The common diode D is connected to $V_{cc}$ and in common to resistors $R_3$ of the word drivers. The cathode of the diode D is connected to a common connection point of resistors $R_3$ and the anode of the diode D is connected to $V_{cc}$. The cathode of diode Da is in this case connected to the common connection point of resistors $R_3$ and its anode is connected to voltage source V.

As will be apparent from the above description, the voltage V to be applied to a word line is a fixed voltage which is preferably at least 0.8 V higher than the writing voltage to be applied to a bit line. This fixed voltage is applied to all the word lines in common. In a selected word line, accordingly, current flows through a path consisting of the resistor Ra, the diode Da and the output transistor $Q_2$ in the second and third embodiments of the present invention, and flows through a path consisting of diode Da, resistor $R_3$ and output transistor $Q_2$ in the case of the fourth embodiment of the present invention. This current is limited by the resistor Ra or by the resistor $R_3$.

As power source for the voltage V to be applied to the word lines, there may well be used, as an alternative to an independent power source, the source of the constant current to be supplied to the programming terminals for writing. In this case, however, the constant-current source needs to include provision for a component which corresponds to the aforementioned current flowing through the path provided by Ra, Da and $Q_2$ or the path provided by $R_3$, Da and $Q_2$.

The problems discussed above arise not only in junction-shorting type memory cells as described above, but also in fuse type memory cells, diode type memory cells, etc., wherever P-N junctions are arrayed in a single land or layer 12.

Embodiments of the present invention are effective when applied to programmable devices employing memory cells of any of the above-mentioned kinds.

Moreover, Schottky diodes may be used as the above-mentioned diodes Da and D.

As set forth above, in embodiments of the present invention the turn-on of a parasitic P-N-P-N element and the outflow of writing current to substrate attributable to the presence of a parasitic P-N-P transistor can be hindered in the programming mode of a programmable device by the simple expedient of applying high voltage to word lines.

## Claims

1. A field programmable bipolar semiconductor memory device, comprising a plurality of word lines ($W_1$, $W_2$, $W_3$, ...), a plurality of bit lines ($B_1$, $B_2$, $B_3$, ...) arranged to cross the word lines, and a plurality of memory cells ($M_{11}$, $M_{12}$, $M_{21}$, $M_{22}$, ...) arrayed in a single semiconductor substrate each connected to a bit line and a word line, characterised in that the device further comprises supply means (T, Da, Ra) operable for supplying non-selected word lines with a voltage sufficient to prevent turn-on of a parasitic P-N-P-N element ($Tr_1$, $Tr_2$) formed by memory cells of the device, and operable for supplying non-selected word lines with a voltage sufficient to prevent leakage of a writing or programming current, delivered via a selected bit line, through a parasitic P-N-P transistor ($Tr_3$) formed in a previously written or programmed memory cell on the selected bit line.

2. A device as claimed in claim 1 comprising a plurality of word drivers (WD), connected to respective word lines ($W_1$, $W_2$, $W_3$, ...), wherein each word driver includes: a first transistor ($Q_1$), having a base arranged to receive an input signal, when the device is in use, a collector arranged for connection to a power source (Vcc), when the device is in use, and an emitter arranged for grounding, when the device is in use, through a first resistor ($R_2$) provided in the word driver; a second transistor ($Q_2$), having a base connected to the emitter of the first transistor ($Q_1$), an emitter arranged for gorunding, when the device is in use, and a collector arranged for connection to the said power source (Vcc), when the device is in use, via a second resistor ($R_3$) provided in the word driver.

3. A device as claimed in claim 2, wherein, in each word driver (WD), the collector of the second transistor ($Q_2$) is arranged for connection to the said power source (Vcc) via the second resistor ($R_3$) and a diode (D) connected in series therewith in the word driver.

4. A device as claimed in claim 2, wherein, in each word driver (WD), the collector of the second transistor ($Q_2$) is arranged for connection to the said power source (Vcc) via the second resistor ($R_3$) and a third transistor ($Q_3$) provided in the word driver.

5. A device as claimed in claim 2, wherein the second resistors ($R_3$) of the word drivers (WD) are connected in common to a diode (D) arranged for connection to the said power source (Vcc).

6. A device as claimed in any preceding claim wherein the supply means comprise respective resistors (Ra) connected to the said plurality of word lines ($W_1$, $W_2$, $W_3$, ...).

7. A device as claimed in any one of claims 1 to 5, wherein the supply means comprise, in respect of each of the said plurality of word lines ($W_1$, $W_2$, $W_3$, ...), a series connection of a resistor (Ra) and a diode (Da).

8. A device as claimed in any one of claims 2 to 5, wherein the supply means comprise a diode (Da) connected in common to the collectors of the second transistors ($Q_2$) of the word drivers (WD), via the respective second resistors ($R_3$) of the word drivers.

9. A device as claimed in claim 8, wherein the supply means are connected to a further power source (V), different from the said power source (Vcc).

10. A device as claimed in claim 9, wherein the further power source (V) provides a voltage at least 0.8 volts higher than the voltage applied to a selected bit line (B$_1$, B$_2$, B$_3$, ...) during writing or programming of a memory cell (M$_{11}$, M$_{12}$, M$_{21}$, ...) along the selected bit line.

11. A device as claimed in any preceding claim, having junction-shorting, fuse or diode type memory cells.

**Revendications**

1. Dispositif de mémoire à semiconducteurs bipolaire programmable au lieu d'emploi, comprenant un ensemble de fils de mot (W$_1$, W$_2$, W$_3$, ...), un ensemble de fils de bit (B$_1$, B$_2$, B$_3$, ...) disposés pour couper les fils de mot, et un ensemble de cellules de mémoire (M$_{11}$, M$_{12}$, M$_{21}$, M$_{22}$, ...) rangées dans un seul substrat semiconducteur et connectées chacune à un fil de bit et à un fil de mot, caractérisé en ce qu'il comprend en outre des moyens d'alimentation (T, Da, Ra) pouvant fonctionner pour fournir aux fils de mot non sélectionnés une tension suffisante pour empêcher la mise en circuit d'un élément P-N-P-N parasite (Tr$_1$, Tr$_2$) formé par des cellules de mémoire du dispositif, et pouvant fonctionner pour fournir aux fils de mot non sélectionnés une tension suffisante pour empêcher la fuite d'un courant d'écriture ou du programmation, délivré par un fil de bit sélectionné, à travers un transistor P-N-P parasite (Tr$_3$) formé dans une cellule de mémoire écrite ou programmée précédemment se trouvant sur le fil de bit sélectionné.

2. Dispositif selon la revendication 1, comprenant un ensemble de circuits de commande de mot (WD), connectés à des fils de mot respectifs (W$_1$, W$_2$, W$_3$, ...), dans lequel chaque circuit de commande de mot comprend: un premier transistor (Q$_1$), ayant une base disposée pour recevoir un signal d'entrée, quand le dispositif est utilisé, un collecteur disposé pour être connecté à une source de tension d'alimentation (Vcc), quand le dispositif est utilisé, et un émetteur disposé pour être relié à la masse, quand le dispositif est utilisé, par l'intermédiaire d'une première résistance (R$_2$) prévue dans le circuit de commande de mot; un deuxième transistor (Q$_2$), ayant une base connectée à l'émetteur du premier transistor (Q$_1$), un émetteur disposé pour être relié à la masse, quand le dispositif est utilisé, et un collecteur disposé pour être connecté à la source de tension d'alimentation (Vcc), quand le dispositif est utilisé, par l'intermédiaire d'une deuxième résistance (R$_3$) prévue dans le circuit de commande de mot.

3. Dispositif selon la revendication 2, dans lequel, dans chaque circuit de commande de mot (WD), le collecteur du deuxième transistor (Q$_2$) est disposé pour être connecté à la source de tension d'alimentation (Vcc) par l'intermédiaire de la deuxième résistance (R$_3$) et d'une diode (D) connectée en série avec celui-ci dans le circuit de commande de mot.

4. Dispositif selon la revendication 2, dans lequel, dans chaque circuit de commande de mot (WD), le collecteur du deuxième transistor (Q$_2$) est disposé pour être connecté à la source de tension d'alimentation (Vcc) par l'intermédiaire de la deuxième résistance (R$_3$) et d'un troisième transistor (Q$_3$) prévu dans le circuit de commande de mot.

5. Dispositif selon la revendication 2, dans lequel les deuxièmes résistances (R$_3$) des circuits de commande de mot (WD) sont connectées en commun à une diode (D) disposée pour être connectée à la source de tension d'alimentation (Vcc).

6. Dispositif selon l'une quelconque des revendications 1 à 5, dans lequel les moyens d'alimentation comprennent des résistances respectives (Ra) connectées à l'ensemble des fils de mot (W$_1$, W$_2$, W$_3$, ...).

7. Dispositif selon l'une quelconque des revendications 1 à 5, dans lequel les moyens d'alimentation comprennent, en ce qui concerne chacun de l'ensemble de fils de mot (W$_1$, W$_2$, W$_3$, ...), une connexion en série d'une résistance (Ra) et d'une diode (Da).

8. Dispositif selon l'une quelconque des revendications 2 à 5, dans lequel les moyens d'alimentation comprennent une diode (Da) connectée en commun aux collecteurs des deuxièmes transistors (Q$_2$) des circuits de commande de mot (WD), par l'intermédiaire des deuxièmes résistances respectives (R$_3$) des circuits de commande de mot.

9. Dispositif selon la revendication 8, dans lequel les moyens d'alimentation sont connectés à une autre source de tension d'alimentation (V), différente de la source de tension d'alimentation (Vcc).

10. Dispositif selon la revendication 9, dans lequel l'autre source de tension d'alimentation (V) fournit une tension au moins supérieure de 0,8 volt à la tension appliquée à un fil de bit sélectionné (B$_1$, B$_2$, B$_3$, ...) pendant une écriture ou une programmation d'une cellule de mémoire (M$_{11}$, M$_{12}$, M$_{21}$, ...) se trouvant le long du fil de bit sélectionné.

11. Dispositif selon l'une quelconque des revendications 1 à 10, comportant des cellules de mémoire du type à mise en courtcircuit de jonction, à fusible ou à diode.

**Patentansprüche**

1. Am Einsatzort programmierbare bipolare Halbleiterspeichervorrichtung, mit einer Vielzahl von Wortleitungen (W$_1$, W$_2$, W$_3$, ...), einer Vielzahl von Bitleitungen (B$_1$, B$_2$, B$_3$, ...), die die Wortleitungen kreuzend angeordnet sind, und einer Vielzahl von Speicherzellen (M$_{11}$, M$_{12}$, M$_{21}$, M$_{22}$, ...), die in einem einzigen Halbleitersubstrat angeordnet und jeweils mit einer Bitleitung und einer Wortleitung verbunden sind, dadurch gekennzeichnet, daß die Vorrichtung ferner Versorgungseinrichtungen (T, Da, Ra) umfaßt, die betreibbar sind, um nicht ausgewählte Wortleitungen mit einer Spannung zu versorgen, die ausreicht, ein Einschalten eines parasitären P-N-P-N-Elementes (Tr$_1$, Tr$_2$) zu verhindern, welches

durch die Speicherzellen der Vorrichtung gebildet wird, und die betreibbar sind, um den nicht ausgewählten Wortleitungen eine Spannung zuzuführen, die ausreicht, um ein Auslecken eines Schreib- oder Programmierstromes, der über eine ausgewählte Bitleitung geliefert wird, durch einen parasitären P-N-P-Transistor ($Tr_3$), der in einer zuvor beschriebenen oder programmierten Speicherzelle gebildet ist, auf der ausgewählten Bitleitung zu verhindern.

2. Vorrichtung nach Anspruch 1, mit einer Vielzahl von Worttreibern (WD), die über entsprechende Wortleitungen ($W_1$, $W_2$, $W_3$, ...) angeschlossen sind, bei welcher jeder Worttreiber umfaßt; einen ersten Transistor ($Q_1$), der eine Basis hat, die so angeordnet ist, daß sie ein Eingangssignal empfängt, wenn die Vorrichtung in Betrieb ist, und einen Kollektor, der zum Anschluß an eine Energiequelle (Vcc) angeordnet ist, wenn die Vorrichtung in Betrieb ist, und einen Emitter, der zur Erdung angeordnet ist, wenn die Vorrichtung in Betrieb ist, über einen ersten Widerstand ($R_2$), der in dem Worttreiber vorgesehen ist; einen zweiten Transistor ($Q_2$), der eine Basis hat, die mit dem Emitter des ersten Transistors ($Q_1$) verbunden ist, einen Emitter, der zur Erdung angeordnet ist, wenn die Vorrichtung in Betrieb ist, und einen Kollektor, der zur Verbindung mit der genannten Energiequelle (Vcc), wenn die Vorrichtung in Betrieb ist, über einen zweiten Widerstand ($R_3$), der in dem Worttreiber vorgesehen ist, angeordnet ist.

3. Vorrichtung nach Anspruch 2, bei welcher in jedem Worttreiber (WD) der Kollektor des zweiten Transistors ($Q_2$) zum Anschluß an die genannte zweite Energiequelle (Vcc) über den zweiten Widerstand ($R_3$) und eine Diode (D), die in Reihe mit diesem in dem Worttreiber angeschlossen ist, angeordnet ist.

4. Vorrichtung nach Anspruch 2, bei welcher in jedem Worttreiber (WD) der Kollektor des zweiten Transistors ($Q_2$) zum Anschluß an die genannte Energiequelle (Vcc) über den zweiten Transistor ($R_3$) und einen dritten Transistor ($Q_3$), der in dem Worttreiber vorgesehen ist, angeordnet ist.

5. Vorrichtung nach Anspruch 2, bei welcher die beiden Widerstände ($R_3$) der Worttreiber (WD) gemeinsam mit einer Diode (D) verbunden sind, die zum Anschluß an die genannte Energiequelle (Vcc) angeordnet ist.

6. Vorrichtung nach einem der vorhergehenden Ansprüche, bei welcher die Versorgungseinrichtung jeweils Widerstände (Ra) umfassen, die mit der genannten Vielzahl von Wortleitungen ($W_1$, $W_2$, $W_3$, ...) verbunden sind.

7. Vorrichtung nach einem der Ansprüche 1 bis 5, bei welcher die Versorgungseinrichtungen, bezüglich jeder der genannten Vielzahl von Wortleitungen ($W_1$, $W_2$, $W_3$, ...), eine Reihenverbindung eines Widerstands (Ra) und eine Diode (Da) umfassen.

8. Vorrichtung nach einem der Ansprüche 2 bis 5, bei welcher die Versorgungseinrichtungen eine Diode (Da) umfassen, die gemeinsam mit den Kollektoren der zweiten Transistoren ($Q_2$) der Worttreiber (WD) über die jeweiligen zweiten Widerstände ($R_3$) der Worttreiber verbunden sind.

9. Vorrichtung nach Anspruch 8, bei welcher die Versorgungseinrichtungen mit einer weiteren Energiequelle (V) verbunden sind, die von die genannten Energiequelle (Vcc) verschieden ist.

10. Vorrichtung nach Anspruch 9, bei welcher die weitere Energiequelle (V) eine Spannung liefert, die wenigstens 0,8 Volt höher als die Spannung ist, die einer ausgewählten Bitleitung ($B_1$, $B_2$, $B_3$, ...) während des Schreibens oder Programmierens einer Speicherzelle ($M_{11}$, $M_{12}$, $M_{21}$, ...) längs der ausgewählten Bitleitung zugeführt wird.

11. Vorrichtung nach einem der vorhergehenden Ansprüche, mit Speicherzellen vom Übergangs-Kurzschluß-, Schmelz- oder Diodentyp.

**0 059 630**

Fig. 1

Fig. 2

Fig. 3

Fig. 4

Fig. 5

Fig. 6 A

Fig. 6 B

Fig. 7

Fig. 8

Fig. 9

Fig. 10

0 059 630

Fig. 11

7